# EUROPEAN PATENT APPLICATION

(11) **EP 1 749 600 A1**
(43) Date of publication of application: **07.02.2007**
(21) Application number: 05728544.7
(22) Date of filing: 11.04.2005
(51) Int. Cl.: B22F 1/02, B22F 1/00, H01B 5/00, H01B 1/22, C23C 26/00, C08K 9/00

(54) **SILVER POWDER COATED WITH SILVER COMPOUND AND MANUFACTURING METHOD THEREOF**

(30) Priority: 14.04.2004 JP 2004119211
(71) Applicant: MITSUI MINING & SMELTING CO., LTD., Tokyo 141-8584 (JP)
(72) Inventor: SASAKI, Takuya, Hikoshima Smelting Co., Ltd., Hikoshima, Shimonoseki Yamaguchi 7500093 (JP); SAKAUE, Takahiko Hikoshima Smelting Co., Ltd., Hikoshima, Shimonoseki Yamaguchi 7500093 (JP); FUJIMOTO, Taku Hikoshima Smelting Co., Ltd., Hikoshima, Shimonoseki Yamaguchi 7500093 (JP); YOSHIMARU, Katsuhiko, Hikoshima Smelting Co. Ltd., Hikoshima, Shimonoseki Yamaguchi 7500093 (JP)
(74) Representative: Bohmann, Armin K.
(86) International application number: PCT/JP2005/007005
(87) International publication number: WO 2005/099939

(57) **Abstract**

The objects of the present invention are to provide silver compound-coated silver powder applicable to a conductive paste for forming conductive interconnections for an electronic circuit by the silver powder coated with a silver compound which is thermally decomposed at lower temperature than a melting point of silver, and also to provide a method for producing the same. The means for achieving the objects involves thermal decomposition of the silver compound which is decomposed at much lower temperature than a melting point of silver to fuse silver compound-coated silver particles to each other by silver from the silver compound during sintering of a substrate on which electronic circuit conductive interconnections are to be formed by the conductive paste which contains the silver compound-coated silver powder containing the silver compound-coated silver particles inwhich the silver particles are coated with the silver compound.

## Description

### Technical Field

The present invention relates to a silver powder comprising silver particles coated with a silver compound, e.g., silver oxide, silver carbonate or silver hexanoate (hereinafter referred to as silver compound-coated silver powder) and a method for producing the same. More specifically, the present invention relates to a silver compound-coated silver powder as a suitable conductive paste material for conductive interconnections for electronic circuit substrates and via holes in multi-layered wiring boards, and a method for producing the same.

### Background Art

Recently, multi-layered wiring boards and the like have been widely used as printed circuit boards with the developments of more compact, more densely integrated electronic devices. A conductive paste has been generally used for forming electronic circuit conductive interconnections on these substrates.

A conductive paste is frequently incorporated with silver powder as a suitable conductive metal because of its high conductivity. Silver has a melting point of 961.93°C. However, it is desirable to sinter silver particles incorporated in the conductive paste with each other at a significantly lower temperature than the melting point, in order to facilitate formation of electronic circuit conductive interconnections, in particular those on multi-layered resin substrates.

One of the common methods for reducing a temperature for sintering metallic particles which constitute metallic powder is to divide them finely. However, dividing metallic powder excessively finely accelerates agglomeration of the metallic particles with each other to deteriorate its dispersibility, which tends to cause troubles, e.g., formation of cavities in the sintered conductive interconnections, uneven conductivity in the conductive interconnection and so forth. It is therefore insufficient to finely divide metallic powder (silver powder in this invention) only for reducing a sintering temperature.

For a conductive paste incorporated with silver powder, on the other hand, sintering of the silver particles at low temperature and high dispersion of the silver powder are essential conditions to be highly conductive for electronic circuit conductive interconnections and highly printable on electronic circuit substrates. Therefore, the problems involved in finely dividing powder have provided challenges to be solved in production of the conductive paste for the present invention.

One of the attempts proposed so far to solve the above problems is mixing finer and coarser silver particles in a given ratio for conductive paste to reduce a sintering temperature of the whole composition, given that finer particles sinter at lower temperature than coarser ones. This technique, however, fails to sufficiently satisfy the required printability, because dispersion of the finer particles in the mixture tends to be insufficient.

In the market of multi-layered wiring boards for electronic device, conductive pastes have been required to secure good electric connection between copper foil and conductive silver paste in via holes in the circuit boards.

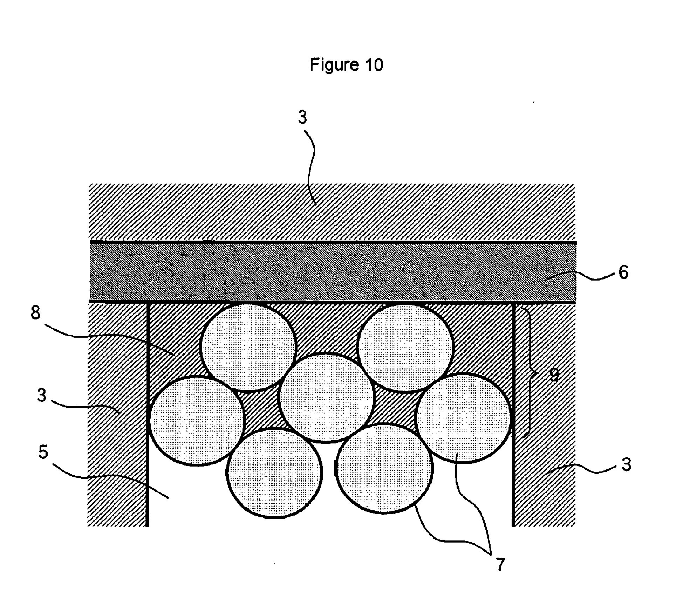

For example, Figure 10 illustrates part of a conventional conductive connection around a via hole (refer to Patent Document 3), which will be briefly described below.

Figure 10 illustrates a conductive connection around a via hole before sintering, comprising an insulating substrate 3, a via hole 5, metallic foil (copper foil) 6, metallic particles (silver particles) 7, a low-melting metal (Sn, In or the like) 8 and a low-melting metallic layer 9 of the low-melting metal 8. The via hole 5 is a through-hole running in the insulating substrate 3 thickness direction to a given depth corresponding to the insulating substrate 3 thickness, although not shown in Figure 10. In Figure 10, another conductive connection of the conceptually same structure (not shown) is located to the lower side of the conductive connection in a linearly symmetrical manner.

The conventional technique illustrated in Figure 10 needs to place the low-melting metal 8 of Sn, In or the like between the copper foil 6 and the silver particles 7 in the silver-containing conductive paste to improve reliability of conductive connection between them. This narrows freedom of formulating conductive silver paste composition and increases the material cost, because it needs time-consuming works for setting adequate Sn or In content, and an additional additive to prevent oxidation of Sn or In. Moreover, the metal 8 having a different ionization tendency from that of the silver 7 contaminates the conductive interconnection by silver to possibly form a local cell.

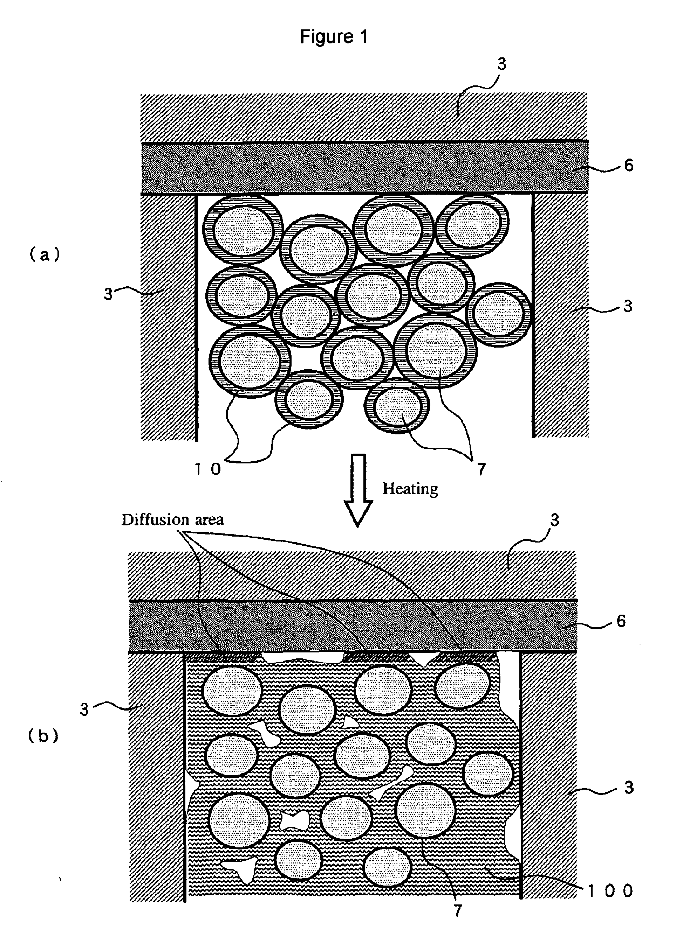

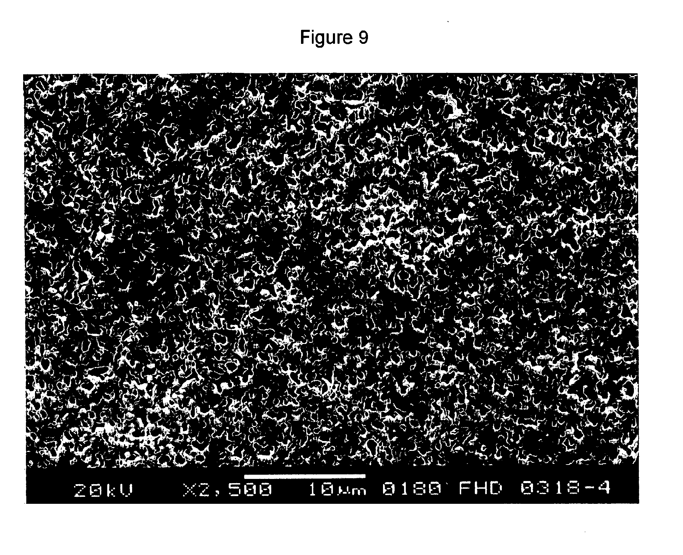

The present invention is described by referring to Figure 1 (a) and Figure 1 (b). Each of the silver particles 7 is coated with a silver compound 10 to adapt itself so that the silver compound 10 can be thermally decomposed at a lower temperature than the melting point of silver. As a result, it is thermally decomposed to form molten silver 100 which works to fuse the silver particles 7 to each other, as illustrated in Figure 1(b), with the result that the molten silver 100 produced by thermal decomposition (hereinafter referred to as the molten silver 100) works as a low-melting metal, e.g. , Sn, In or the like, used in the conventional technique. The term "fuse" used in this specification means bonding of the silver particles to each other via the molten silver 100. In this technique, the molten silver 100 facilitates creation of bridges between the silver particles 7 before the conductive interconnection of elementary silver is formed by sintering (refer to Figure 9, which presents an SEM photograph). Therefore, it saves works of formulating and mixing dissimilar metals, which are essential for the conventional technique. Moreover, it produces no local cell between dissimilar metals, because the conductive interconnection is basically of silver alone.

The silver particles start to melt as the structure illustrated in Figure 1(b) is sintered to fill cavities 11 with the molten silver to form a conductive interconnection of silver in the via hole.

It is to be understood that Figures 1 and 10 present conceptual conductive interconnections of the present invention and conventional technique for illustrative purposes, and relative sizes of the components and particle diameter are different from those of actual ones.

[Patent Document 1] JP 2002-324966 A
[Patent Document 2] JP 2002-334618 A
[Patent Document 3] JP 11-214575 A

### Brief Description of the Drawings

Figure 1 illustrates a conceptual conductive portion in a via hole, which is formed by a conductive paste (of silver powder) containing the silver compound-coated silver particles of the present invention, where Figure 1(a) illustrates the inside of a conceptual via hole before sintering; and Figure 1(b) illustrates the inside of a via hole during the sintering step and after the sintering temperature has reached beyond the thermal decomposition temperature of a silver compound to decompose it into silver;
Figure 2 shows a flow chart which illustrates a best mode of carrying out of the present invention;
Figure 3 shows a flow chart for illustrating Example 1 according to the present invention;
Figure 4 shows a flow chart for illustrating Example 2 according to the present invention;
Figure 5 shows a flow chart for illustrating Example 3 according to the present invention;
Figure 6 shows a flow chart for illustrating Example 4 according to the present invention;
Figure 7 shows a flow chart for illustrating Example 5 according to the present invention;
Figure 8(a) is an SEM photograph which shows silver particles before they are coated with a silver compound, and Figure 8(b) is an SEM photograph which shows the silver particles coated with a silver compound;
Figure 9 is an SEM photograph which shows the state where the silver particles fused to each other while the silver compound-coated silver particles are sintered; and
Figure 10 illustrates a conceptual conductive portion around a via hole, formed by a conventional technique which uses a mixed powder of silver particles and a low-melting metal.

### Disclosure of the Invention

The objects of the present invention are to reduce a temperature at which silver particles are sintered together, to realize an electrical conductive interconnection with a conductive silver paste, formed without having to use a low-melting metal such as Sn or In, and to improve adhesion between the conductive silver paste and copper foil.

The inventors of the present invention have found, as a result of extensive study, that a silver compound-coated silver powder containing silver compound-coated silver particles in which silver particles are coated with a silver compound gives a conductive silver paste which can solve the problems involved in the conventional technique to achieve the above objects.

### <Silver compound-coated silver powder>

The silver compound-coated silver powder of the present invention is described below.
The present invention provides a silver compound-coated silver powder containing silver compound-coated silver particles which have silver particles working as the cores and a silver compound coating the silver particles.

The present invention also provides the silver compound-coated silver powder having the following powder properties:
a. SSA (m²/g): 0.1 to 5
b. D₅₀ (µm) : 0.1 to 10
c. Dmax (µm): 0.5 to 30 (where, SSA is specific surface area determined by BET method, D₅₀ is 50% volumetric cumulative particle diameter, and Dmax is maximum volumetric cumulative particle diameter, determined by a laser diffraction/scattering particle size distribution analyzer).

The reason why the ranges of the powder properties are specified will be described below.
a. For SSA (m²/g), the particles may not be sufficiently sintered at low temperature when it is below 0.1, and may be difficult to paste when it is above 5 because they absorb oil excessively during the paste producing step.

b. For D₅₀ (µm), the particles may be difficult to paste when it is below 0.1 because they absorb oil excessively during the paste producing step, and they may not be divided sufficiently finely for well interconnecting electronic circuits on a substrate when it is above 10.

c. For Dmax (µm), the particles may be practically difficult to produce when it is below 0.5, and may not give a conductive paste which can be spread smoothly when it is above 30.

In the present invention, the silver powder is coated with the silver compound at 5 to 30% by weight to 100% by weight of the silver compound-coated silver powder, preferably at 10 to 20% by weight.

Below 5% by weight to 100% by weight of the silver compound silver powder, the silver compound may be insufficient in quantity to create bridges between the silver particles. Above 30% by weight, on the other hand, it may not be thermally decomposed smoothly, and may fail to allow for smooth sintering between the silver particles with each other and production of good conductive interconnections.

The present invention provides the silver compound-coated silver powder characterized in that the silver particles are well fused to each other by silver from the silver compound decomposed at a lower temperature than a temperature for sintering together the silver particles of the silver compound-coated silver powder, as illustrated in Figure 1.

Silver, which has a melting point of 961.93°C, can have a greatly decreased temperature for sintering together the silver particles when finely divided. However, dividing silver excessively finely causes problems, e.g., accelerated agglomeration of the particles, as discussed earlier.

Therefore, the present invention coats silver particles with a silver compound which can be thermally decomposed at much lower temperature than ameltingpoint of silver (961.93°C), e.g. , silver oxide which is decomposed at 160°C. As a result, silver oxide or the like coating the silver particles is thermally decomposed during the sintering step for forming conductive interconnections on an electronic circuit substrate and the resulting silver fuses to the adjacent silver particles.

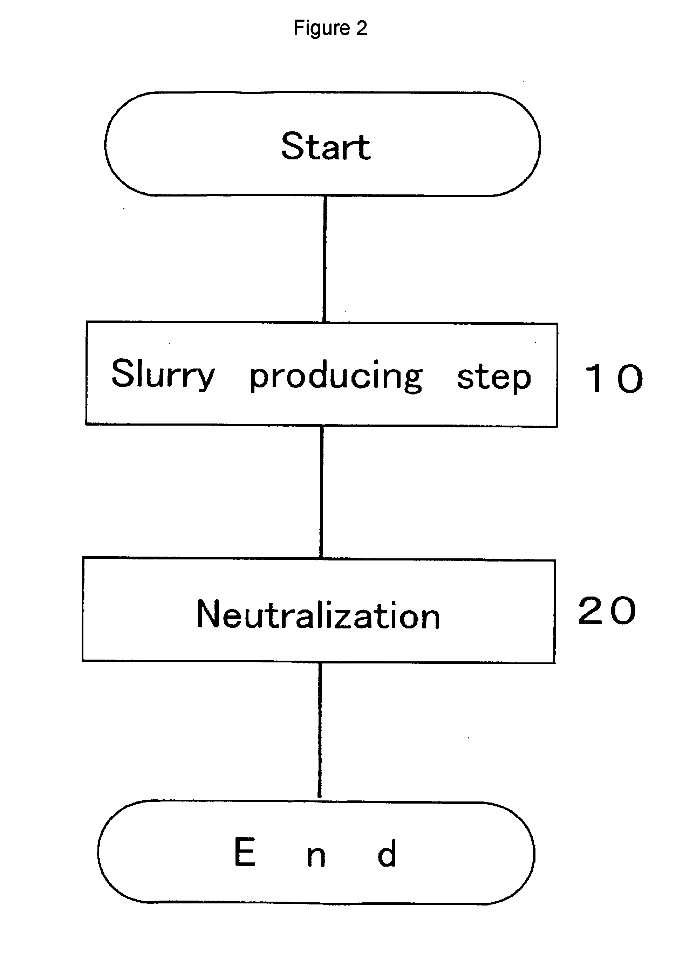

Therefore, the silver compound coating, which works as the finely divided silver powder used in a conventional technique (refer to Figure 2 in Patent Document 2), solves the above problems resulting from insufficient dispersion of the finely divided silver powder in the mixture.

Moreover, it also solves the problems involved in a conventional technique resulting from contamination of the conductive paste with a low-melting metal, e.g., Sn, In or the like (refer to Figure 1 in Patent Document 3), to realize high conductivity brought by pure silver metal.

Therefore, the conductive paste of the present invention, when applied to a via hole in a multi-layered resin substrate, can realize high conduction between copper wiring portions on the lower and upper adjacent substrate layers and connected to each other via silver.

In the present invention, the silver particle sintering can be started almost simultaneously with the silver compound decomposition, when size of the silver particles is set in such a way that agglomeration of the silver particles is prevented, and that a fine silver particle sintering temperature is set at as close to a silver compound decomposition temperature as possible.

However, it is needless to say that the size of the silver particles can be set in such a way that they are sintered above the thermal decomposition temperature described above. In other words, it is considered that silver from the thermally decomposed silver compound fuses to the adjacent silver particles and then sintering of the silver particles with each other starts, even when the silver particle sintering temperature is much higher than the silver compound decomposition temperature.

Figure 9 is an SEM photograph illustrating the silver particles being sintered with each other while the silver compound-coated silver powder is sintered. It is considered, as illustrated, that the silver particles are first sintered with each other to form a net-work structure, and the black portions shown in the figure are eventually filled with the silver particles to form the conductive interconnection of silver, and that the molten silver from the thermally decomposed silver compound (e.g., silver oxide) coating the silver particles serves as a momentum for starting sintering of the silver particles with each other.

Moreover, the present invention provides the silver compound-coated silver powder characterized in that they are dampened with an organic solvent.

Still more, the present invention provides the silver compound-coated silver powder characterized in that they are incorporated in a conductive paste to produce a conductive silver paste.

### <Method for producing silver compound-coated silver powder>

The present invention also provides a method for producing silver compound-coated silver powder containing silver compound-coated silver particles in which the particles of the silver powder are coated with a silver compound, the method comprising steps (a) and (b), wherein the step (a) is a slurry producing step for incorporating the silver powder in an aqueous silver nitrate solution with stirring to produce a slurry and well dispersing the silver powder in the aqueous silver nitrate solution, and the step (b) is a neutralization step for incorporating the slurry with an equivalent quantity of basic solution, e.g., sodium or ammonium hydroxide solution for neutralization to coat the silver particles with the silver compound.

The present invention can add a step for washing the silver compound-coated silver powder produced by the step (b) with water and a step for drying the silver compound-coated silver powder washed in the washing step to the above method. The water for the washing step is preferably pure water.

The dried silver compound-coated silver powder can be produced by treating the silver compound-coated silver powder in the washing step with a volatile organic solvent, e.g., methanol, ethanol, acetone, methylethylketone, methylisobutylketone, isobutanol, isopropanol, hexane, toluene, terpineol or butylcarbitolacetate to remove water from the powder.

The silver compound-coated silver powder can be dampened, after being washed with a volatile solution or after being dried, with a solvent similar to the above described volatile organic solvent, to provide the powder dampened with an organic solvent.

The method for producing silver compound-coated silver powder is described in more detail in "Best Mode for Carrying out the Invention."

The silver compound-coated silver powder of the present invention can reduce a temperature for sintering the silver particles with each other by coating the silver particles with a silver compound to dispense with inclusion of a low-melting metal, e.g., Sn, In or the like; achieve sintering which realizes electrical connection (conductive interconnection) by highly conductive silver; and improve adhesion of a conductive paste incorporated with the silver powder to copper foil.

### Best Mode for Carrying Out the Invention

The best mode for carrying out the invention will be described below.

Figure 2 shows a flow chart which illustrates the process for producing the silver compound-coated silver powder of the present invention. Quantities of reagents, solutions and the like are used in the following descriptions, but the present invention is not limited by these values. It is needless to say that those skilled in the art can modify these quantities and other conditions in accordance with pilot or commercial scale.

As illustrated in Figure 2, the process for producing the silver compound-coated silver powder comprises a slurry producing step 10 and a neutralization step 20.

In the slurry producing step 10, 4 to 250 g of silver nitrate is dissolved in about 1000 cc of water (preferably pure water), and the resulting aqueous silver nitrate solution is incorporated with 10 to 300 g of silver powder (average particle size: 0.2 to 10 µm) with stirring to produce a slurry and allowed to well disperse the silver powder in the aqueous silver nitrate solution.

In the neutralization step 20, the slurry prepared in the slurry producing step 10 is incorporated with a basic solution, e.g., sodiumorammoniumhydroxide solution, at least at an equivalent quantity necessary for neutralizing the nitrate ion (NO₃⁻) for neutralization to coat the silver particles as the cores with a silver compound by the following reaction, where silver oxide (Ag₂O) is used as a representative silver compound and sodium hydroxide is used as the basic solution.

2AgNO₃ + 2NaOH → Ag₂O + 2NaNO₃ + H₂O

The silver particles may be coated with the silver compound either partly or totally, desirably totally.

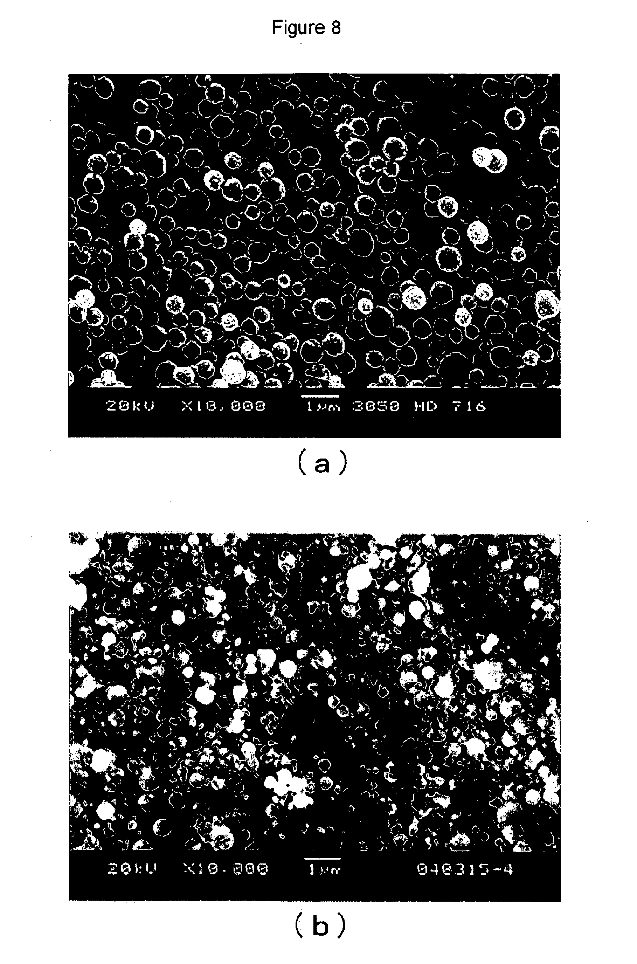

Figure 8 (a) is an SEM photograph which shows the silver particles before being coated with the silver compound, and Figure 8(b) is an SEM photograph which shows the silver particles coated with the silver compound. As shown in Figure 8(b), the silver particles are not totally coated with the silver compound, as part of the silver compound sticks or attaches to the particles in a point-like or island-like manner. Therefore, the term "coated" used in this specification covers attachment of the compound in a point-like or island-like manner.

Extent of coating of the silver compound-coated silver powder of the present invention with the silver compound is determined by a thermogravimetric-differential thermal analyzer (TG-DTA, TG/DTA6300, Seiko Instruments) under conditions of air rate: 150 mL/minute and heating rate: 2°C/minute with 15 mg of the silver compound-coated silver powder sample.

An example of determining coating extent with silver oxide as a representative silver compound by a TG-DTA is described. Silver nitrate was charged at a rate set to give a silver oxide coating extent of 10% by weight. A coating extent of 11.6% by weight could be obtained at an O (oxygen) /Ag₂O (silver oxide) ratio of 6.89% by weight on the basis that loss of the sample heated to 200°C in the analyzer is 0.8% by weight (0.8/6.89 × 100 = 11.6% by weight). In this manner, the coating level at % by weight of silver particles with silver oxide was determined. The measurement was repeated 10 times under the same conditions to confirm repeatability. The measured coating extents were within a range from 9.8 to 12.9% by weight, which means that the target level of 10% by weight was almost provided.

In the silver oxide coated silver powder of the present invention, in order to coat the silver powder with silver oxide at 5 to 30% by weight on 100% by weight of the silver oxide coated silver powder, silver nitrate is charged adequately at a rate of 7.25 to 43.8% by weight.

Silver nitrate is an essential compound for producing the silver compound. Therefore, the conditions of producing either of the other two of silver compounds, silver carbonate and silver hexanoate at a suitable coating level may be set in the same way as those set for silver oxide.

Returning back to Figure 2, the description is continued. The neutralization step 20 may be followed by a washing step for washing the silver compound-coated silver powder of the present invention and a drying step for removing moisture carried by the silver compound-coated silver powder in the neutralization step 20 by its evaporation together with a volatile solvent.

In the washing step, the silver compound-coated silver powder produced by the neutralization step 20, shown in Figure 1, is washed with 100 to 10,000 cc of water (preferably pure water), and then treated with 10 to 10,000 cc of a volatile solvent, e.g., methanol, ethanol, acetone, methylethylketone, methylisobutylketone, isobutanol, isopropanol, hexane, toluene, terpineol or butylcarbitolacetate in the drying step to dry the silver compound-coated silver powder by removing moisture contained therein together with the volatile solvent.

The present invention is described more specifically by Examples.

### [Example 1]

### <Production of silver oxide coated silver powder by the process (1) comprising a neutralization step with sodium hydroxide (NaOH)>

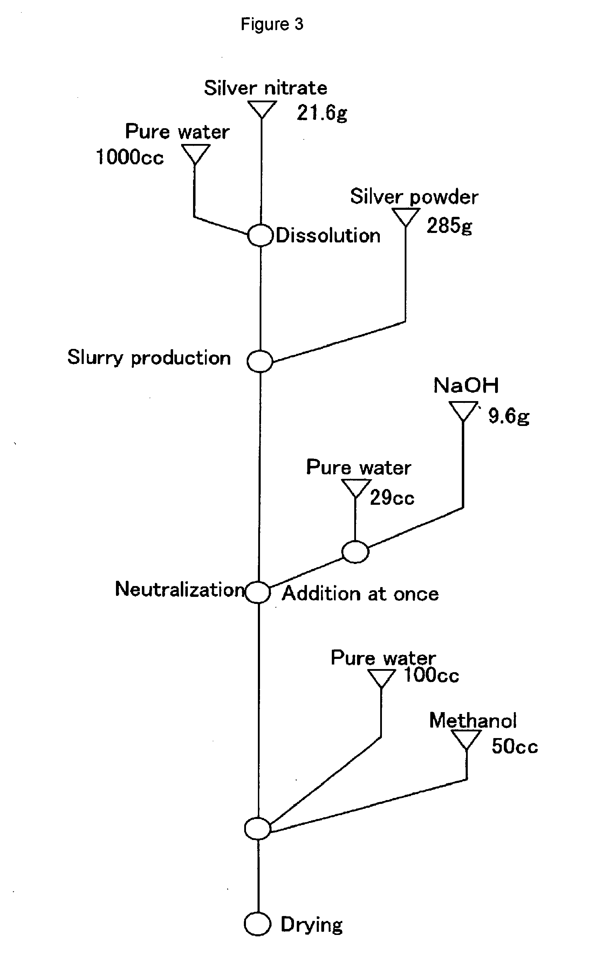

Figure 3 shows a flow chart of the process for producing silver oxide coated silver powder in Example 1 of the present invention. The process of Example 1 specifically involves the neutralization step with sodium hydroxide.

Example 1 is described below by referring to Figure 3.
(1) First, 21.6 g of silver nitrate is dissolved in 1000 cc of pure water, and the resulting aqueous silver nitrate solution is incorporated with 285 g of silver powder to prepare a slurry with stirring. The mixture is allowed to stand for 5 minutes to well disperse the silver powder totally in the aqueous silver nitrate solution.
(2) Then, the slurry is incorporated with an aqueous solution with 9.6 g of sodium hydroxide dissolved in 29 cc of pure water for the neutralization treatment. Thus, the particles of the silver powder can be coated with silver oxide.
(3) For drying the resulting silver oxide coated silver powder, it is treated with 100 cc of pure water and 50 cc of methanol with stirring for washing and dehydration, to prepare the dried silver oxide coated silver powder.

### [Example 2]

### < Production of silver oxide coated silver powder by the process which involves a neutralization step with ammonium hydroxide (NH₄OH) >

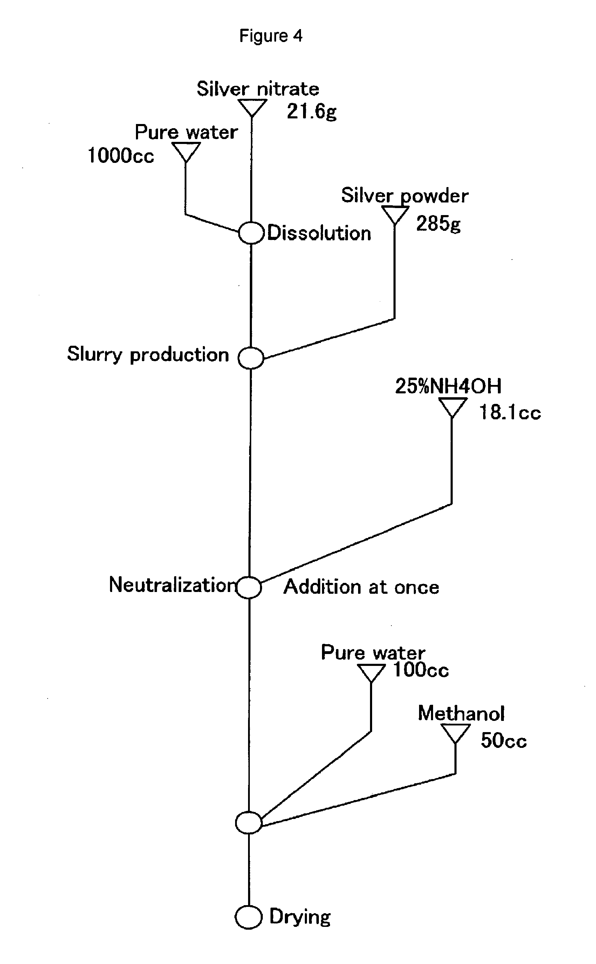

Figure 4 shows a flow chart of the process for producing silver oxide coated silver powder in Example 2 of the present invention. The process of Example 2 specifically involves the neutralization step with ammonium hydroxide.

Example 2 is described below by referring to Figure 4.
(1) First, 21.6 g of silver nitrate is dissolved in 1000 cc of water (preferably pure water), and the resulting aqueous silver nitrate solution is incorporated with 285 g of silver powder to prepare a slurry with stirring. The mixture is allowed to stand for 5 minutes to well disperse the silver powder totally in the aqueous silver nitrate solution.
(2) Then, the slurry is incorporated with 18.1 mL of ammonium hydroxide containing NH₃ at 25% by weight for the neutralization treatment. This can coat the particles of the silver powder with silver oxide.
(3) For drying the resulting silver oxide coated silver powder, it is treated with 100 cc of water (preferably pure water) and 50 cc of methanol with stirring for washing and dehydration, to prepare the dried silver oxide coated silver powder.

### [Example 3]

### <Production of silver oxide coated silver powder by the process (2) which involves a neutralization step with sodium hydroxide (NaOH)>

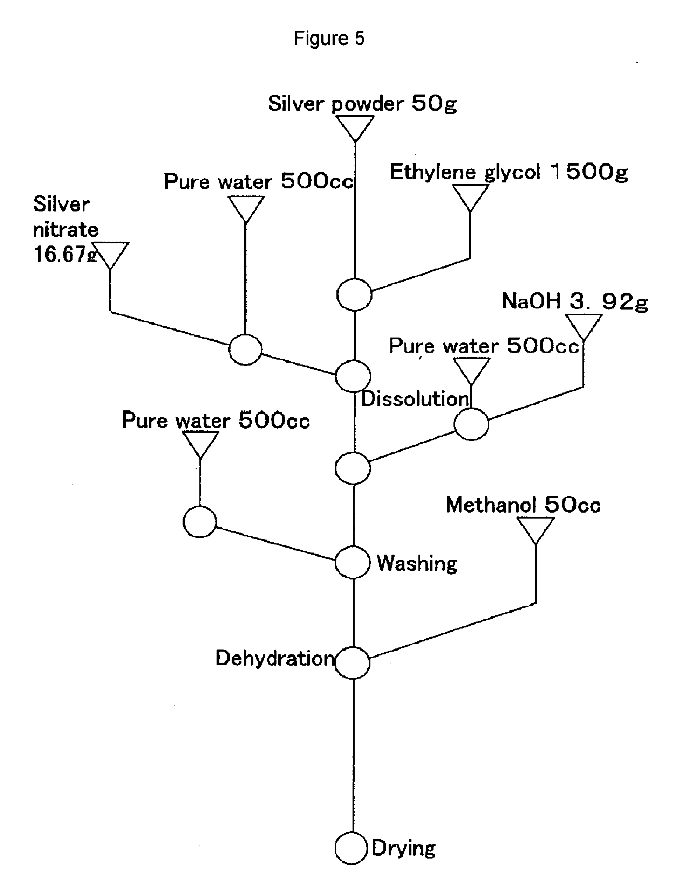

Figure 5 shows a flow chart of the process for producing silver oxide coated silver powder in Example 3 of the present invention. In particular, Example 3 is a modification of Example 1, and differs in that the silver powder is dispersed in ethylene glycol in place of 1000 cc of pure water used in Example 1 to prepare the ethylene glycol dispersion of the silver powder prior to the slurry producing step. The powder is more dispersible in ethylene glycol than in water (pure water).

Example 3 is described below by referring to Figure 5.
(1) First, 50 g of silver nitrate is dissolved in 1500 g of ethylene glycol, and the resulting ethylene glycol solution dispersed with the silver powder is incorporated with 16.67 g of silver powder together with 500 cc of water (preferably pure water) to prepare a slurry with stirring. The mixture is allowed to well disperse the silver powder totally in the silver nitrate solution.
(2) Then, the slurry is incorporated with an aqueous solution with 3.92 g of sodium hydroxide dissolved in 500 cc of water (preferably pure water) for the neutralization treatment. This can coat the particles of the silver powder with silver oxide.
(3) For drying the resulting silver oxide coated silver powder, it is treated with 500 cc of pure water and 50 cc of methanol with stirring for washing and dehydration, to prepare the dried silver oxide coated silver powder.

### [Example 4]

### <Production of silver carbonate coated silver powder by the process which involves a neutralization step with sodium hydrogen carbonate (NaHCO₃)>

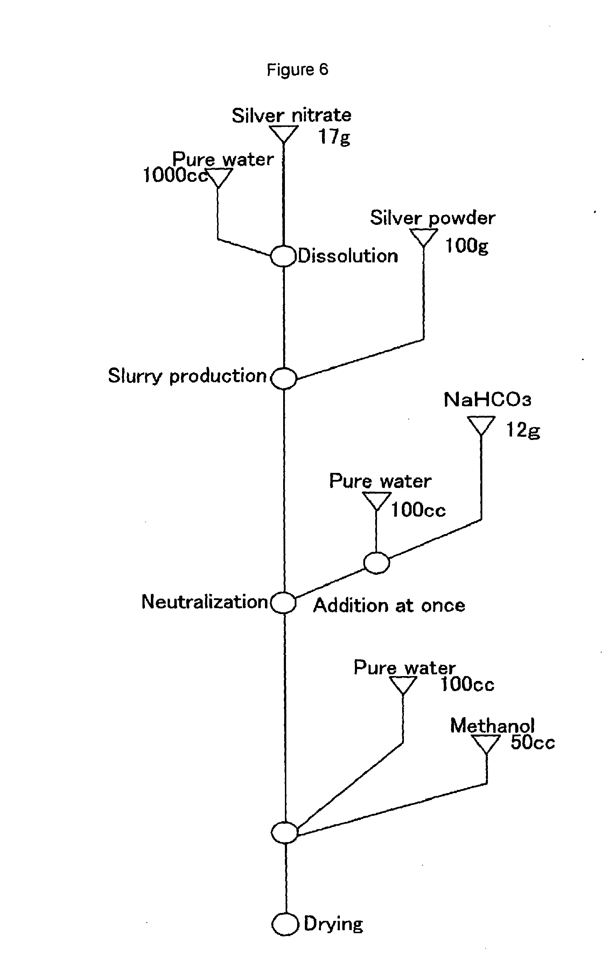

Example 6 is described below by referring to Figure 6.
(1) First, 17 g of silver nitrate is dissolved in 1000 cc of pure water, and the resulting aqueous silver nitrate solution is incorporated with 100 g of silver powder to prepare a slurry with stirring. The mixture is allowed to stand for 5 minutes to well disperse the silver powder totally in the aqueous silver nitrate solution.
(2) Then, the slurry is incorporated with an aqueous solution with 12 g of sodium hydrogen carbonate dissolved in 100 cc of pure water for the neutralization treatment. Thus, the particles of the silver powder can be coated with silver carbonate.
(3) For drying the resulting silver carbonate coated silver powder is treated with 100 cc of pure water and 50 cc of methanol with stirring for washing and dehydration, to prepare the dried silver carbonate coated silver powder.

### [Example 5]

### <Production of silver hexanoate coated silver powder by the process which involves a neutralization step with sodium hexanoate (CH₃(CH₂)₄COONa)>

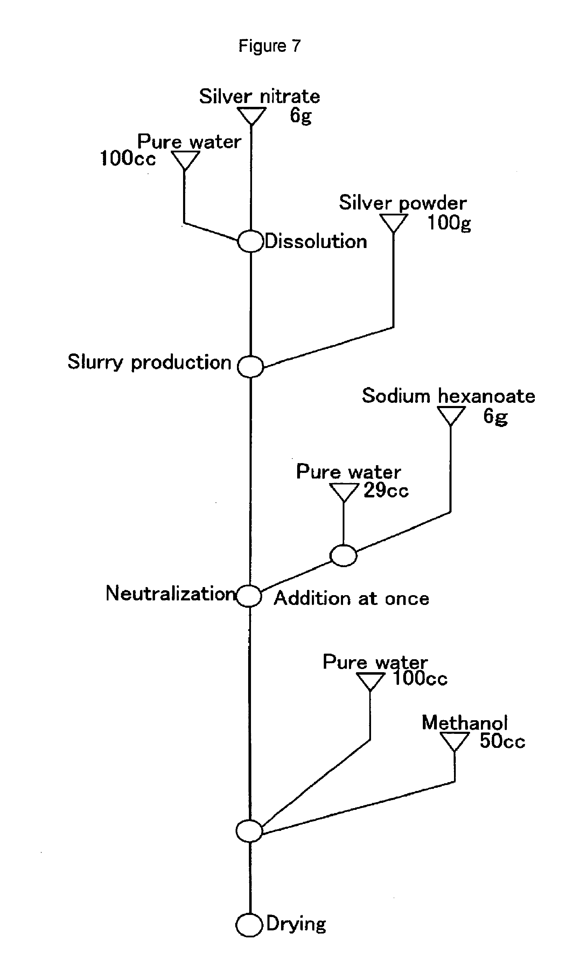

Example 5 is described below by referring to Figure 7.

(1) First, 6 g of silver nitrate is dissolved in 100 cc of pure water, and the resulting aqueous silver nitrate solution is incorporated with 100 g of silver powder to prepare a slurry with stirring. The mixture is allowed to stand for 5 minutes to well disperse the silver powder totally in the aqueous silver nitrate solution.
(2) Then, the slurry is incorporated with an aqueous solution with 6 g of sodium hexanoate dissolved in 100 cc of pure water for the neutralization treatment. This can coat the particles of the silver powder with silver hexanoate.
(3) For drying the resulting silver hexanoate coated silver powder, it is treated with 100 cc of pure water and 50 cc of methanol with stirring for washing and dehydration, to prepare the dried silver hexanoate coated silver powder.

### <Evaluation of the silver compound-coated silver powder prepared in Examples 1 to 5 and Comparative Examples 1 and 2>

Table 1 summarizes the evaluation results of the silver compound-coated silver powders prepared in Examples 1 to 5 and Comparative Examples 1 and 2.

The essential evaluation items are resistivity (µΩ·m) related to a conductive paste incorporated with each silver compound-coated silver powder, and adhesion of the paste to copper foil, which depends on a treatment temperature and a treatment time. The samples of Examples and Comparative Examples were prepared to have the same SSA, D₅₀, Dmax and crystallite diameter to evaluate them accurately and impartially. The "crystallite diameter" was analyzed by the Wilson method, which determines crystallite diameter by X-ray diffractometry using an X-ray diffractometer (RINT2000, Rigaku Denki).

### <Production of conductive paste>

Each conductive paste of the present invention was prepared by kneading to have a composition of 85% of each silver compound-coated silver powder, 0.75% of ethyl cellulose and 14.25% of turpineol, all percentages by weight.

### <Measurement of resistivity>

A paste from each silver compound-coated silver powder of the present invention was used to prepare a 1 mm wide circuit on a ceramic substrate, which was sintered at 150 to 180°C, to determine its resistivity.

### <Measurement of adhesion to copper foil>

A conductive paste same as the above paste was prepared to spread it on copper foil, 5 cm by 2 cm in area and about 30 µm thick (the foil was the same one as the one to which the conductive paste incorporated with the powder of the present invention is applied) to a thickness of 500 µm over the essentially entire surface using a coater (Model YOA, Yoshimitsu Seiki). Then, another copper foil of the same size was placed on the coated side of the foil. Then, the 2 sheets of copper foil with the conductive paste in-between were held between 2 ceramic substrates, each 10 cm by 3 cm in area and about 500 µm thick. The layered structure was held by a simple utensil, e.g., double clip (BCS-30 (silver), ITOCHU), and totally heated in a constant-temperature bath kept at 150°C for 1 hour.

On completion of the heating, it was naturally cooled and the clips were removed to qualitatively analyze adhesion between 2 sheets of foil by pinching each one with a thumb and a forefinger at each end. The results are given in Table 1 in the given column, where the adhesion was evaluated by the following standards:
Satisfactory: Adhesion observed between 2 sheets of foil
Unsatisfactory: No adhesion observed between 2 sheets of foil

It is desirable to quantitatively compare the adhesion of the copper foils prepared in Examples 1 to 5 with that prepared in Comparative Examples 1 and 2 by measuring the adhesion in accordance with the relevant JIS standard or the like. However, no adhesion between 2 sheets of foil was observed with the sample prepared in each of Comparative Examples 1 and 2, whereas the sample prepared in each of Examples 1 to 5 exhibited that the foil adhered to each other to an extent that the foil was broken when peeled off forcefully, observed in the manual qualitative test described above. The adhesion test in this application, therefore, was limited to the qualitative one, because of difficulty of quantitative test of significance (refer to Table 1).

### <Discussion of the evaluation results observed in Examples 1 to 5 and Comparative Examples 1 and 2>

### (1) Evaluation of resistivity:

As shown in Table 1, the wiring portion prepared in each of Examples 1 to 5, where the conductive paste containing the silver compound-coated silver powder of the present invention was used, and in Comparative Example 2 had a practically feasible resistivity. However, resistivity of the wiring portion prepared in Comparative Example 1 could not be measured.

(2) Evaluation of adhesion between copper foil and silver:
As shown in Table 1, the conductive paste of the silver compound-coated silver powder exhibited good adhesion to the copper foil, when theywere treated at 150°C for 1 hour (Examples 1 to 5). By contrast, the paste containing no silver compound-coated silver powder failed to exhibit good adhesion to the copper foil when treated at 150°C for 1 hour and even when treated at higher 180°C for 1 hour (Comparative Examples 1 and 2). It is thus found that the silver compound coating the particles of the silver powder according to the present invention reduces a temperature of sintering the silver particles with each other and improves adhesion to the copper foil.

**[Table 1]**

| | Neutralizing agent | SSA (m²/g ) | D₅₀ (µm) | Dmax (µm) | Crystallite diameter (nm) | Resistivity (µΩ·m) | Adhesion to copper foil | |
|---|---|---|---|---|---|---|---|---|
| | | | | | | | Treatment temperature × time | Evaluation |
| Example 1 | NaOH | 3.73 | 0.31 | 0.98 | 7 | 4.1 | 150°C × 1 hr | Satisfactory |
| Example 2 | NH₄OH | 3.65 | 0.29 | 0.97 | 7 | 3.7 | 150°C × 1 hr | Satisfactory |
| Example 3 | NaOH* | 3.59 | 0.31 | 0.89 | 7 | 3.4 | 150°C × 1 hr | Satisfactory |
| Example 4 | NaHCO₃ | 3.52 | 0.31 | 0.96 | 7 | 2.5 | 150°C × 1 hr | Satisfactory |
| Example 5 | Sodium hexanoate | 3.65 | 0.32 | 0.95 | 7 | 3.1 | 150°C × 1 hr | Satisfactory |
| Comparative Example 1 Containing only Ag | No neutralization (coated with silver powder having no silver compound-coated) | 2.54 | 0.31 | 0.97 | 7 | Could not be measured | 150°C × 1 hr | Unsatisfactory |
| Comparative Example 2 Containing only Ag | No neutralization (coated with silver powder having no silver compound-coated) | 2.54 | 0.31 | 0.97 | 7 | 7.9 | 180°C × 1 hr | Unsatisfactory |

| | | | | | | | | |
|---|---|---|---|---|---|---|---|---|
| (Note) NaOH* : The data with silver oxide coated silver powder prepared by first dispersing the silver powder in an ethylene glycol solution. | | | | | | | | |

### Industrial Applicability

The silver compound-coated silver powder and the method for producing the same, according to the present invention, are applicable to a conductive material for conductive paste to form electronic circuit conductive interconnections, e.g., those in via holes in multi-layered resin substrates.

## Claims

1. A silver compound-coated silver powder, wherein the powder comprises silver compound-coated silver particles comprising silver particles as core and a coating portion coated with a silver compound on the surface of the silver particles.

2. The silver compound-coated silver powder according to Claim 1, comprising silver compound-coated silver particles wherein the silver compound is any one of silver oxide, silver carbonate and silver hexanoate.

3. The silver compound-coated silver powder according to Claim 1 or 2, which has the following powder properties:
a. SSA (m²/g) : 0.1 to 5
b. D₅₀ (µm) : 0.1 to 10
c. Dmax (µm) : 0.5 to 30 (where, SSA is specific surface area determined by BET method, D₅₀ is 50% volumetric cumulative particle diameter, and Dmax is maximum volumetric cumulative particle diameter, determined by a laser diffraction/scattering particle size distribution analyzer).

4. The silver compound-coated silver powder according to any one of Claims 1, 2 and 3, **characterized in that** the silver particles are coated with the silver compound at 5 to 30% by weight on 100% by weight of the coated silver particles.

5. The silver compound-coated silver powder according to any one of Claims 1, 2, 3 and 4, **characterized by** being dampened with an organic solvent.

6. The silver compound-coated silver powder according to any one of Claims 1, 2, 3, 4, and 5, **characterized by** being incorporated in a conductive paste to produce a conductive silver paste.

7. A method for producing silver compound-coated silver powder containing silver compound-coated silver particles in which the silver particles are coated with a silver compound, the method comprising steps (a) and (b), wherein
the step (a) is a slurry producing step for incorporating the silver powder in an aqueous silver nitrate solution with stirring to produce a slurry and well dispersing the silver powder in the aqueous silver nitrate solution, and
the step (b) is a neutralization step for neutralizing the slurry with an equivalent quantity of neutralizing agent necessary for neutralizing the nitrate ion to coat the particles of the silver powder with the silver compound.

8. The method for producing silver compound-coated silver powder according to Claim 7, **characterized in that** the neutralizing agent is a basic solution.

9. The method for producing silver compound-coated silver powder according to Claim 8, **characterized in that** the basic solution is any one of a sodium hydroxide, sodium hydrogen carbonate and sodium hexanoate solutions.
